# EUROPÄISCHE PATENTSCHRIFT

(11) **EP 0 356 740 B1**
(45) Veröffentlichungstag und Bekanntmachung des Hinweises auf die Patenterteilung: **26.01.1994**
(21) Anmeldenummer: 89114214.3
(22) Anmeldetag: 01.08.1989
(51) Int. Cl.: H03K 3/283

(54) **Quarzoszillatorschaltung für höhere Frequenzen**
Quartz oscillator circuit for higher frequencies
Circuit oscillateur à quartz pour fréquences élévées

(30) Priorität: 03.08.1988 DE 3826430
(43) Veröffentlichungstag der Anmeldung: 07.03.1990
(73) Patentinhaber: SIEMENS AKTIENGESELLSCHAFT, 80333 München (DE)
(72) Erfinder: Donig, Günter, Dipl.-Ing.(FH), D-8012 Ottobrunn (DE)

(56) Entgegenhaltungen:
- DE-A- 2 917 374
- US-A- 4 083 019
- US-A- 4 468 636
- IEEE TRANSACTIONS ON COMMUNICATIONS, Band COM-27, Nr. 2, Februar 1979, Seiten 413-419, IEEE, New York, US; E.N. MURTHI: "A monolithic phase-locked loop with post detection processor"
- U. Tietze und Ch. Schenk, Halbleiterschaltungstechnik, Berlin 1985, Seite 451

## Beschreibung

Die Erfindung bezieht sich auf eine Quarzoszillatorschaltung für höhere Frequenzen nach dem Oberbegriff des Anspruchs 1.

Quarzoszillatorschaltungen für höhere Frequenzen sind unter anderem aus Tietze-Schenk, Halbleiterschaltungstechnik, Berlin 1985, S. 451 bekannt, wobei für sehr hohe Frequenzen vorzugsweise emittergekoppelte Quarzmultivibratoren Verwendung finden. Diese bestehen beispielsweise aus zwei Transistoren, die jeweils kollektorseitig über einen Widerstand an einem Pol und emitterseitig über einen weiteren Widerstand an dem anderen Pol einer Versorgungsspannungsquelle angeschlossen sind. Häufig werden die beiden Emitterwiderstände auch durch zwei Stromeinprägungen ersetzt. Die Verknüpfung der beiden Transistoren untereinander erfolgt zum einen durch eine wechselspannungsmäßige Kopplung ihrer Emitter über einen Schwingquarz, zum anderen durch eine Verbindung der Basis eines Transistors mit dem Kollektor des anderen Transistors und umgekehrt. An den Kollektoren der beiden Transistoren liegen die Ausgangssignale einander gegenüber gegenphasig an. Die Stärke der Emitterkopplung läßt sich über die Steilheit der Transistoren mit Hilfe der Emitterwiderstände bzw. der Stromeinprägungen einstellen und wird meistens so gewählt, daß die Schaltung sicher anschwingt, aber nicht zu stark übersteuert.

Die Anschwingdauer derartiger Quarzoszillatorschaltungen wird bei verschiedenen Anwendungsfällen bisweilen als zu groß empfunden. Eine Veringerung der Anschwingdauer beispielsweise durch Erhöhen der Emitterströme der beiden Transistoren ist nur in einem sehr begrenzten Bereich bei stärkerer Aussteuerung und einer damit verbundenen Erhöhung der Verzerrungen möglich.

Aufgabe der Erfindung ist es, bei einer Quarzoszillatorschaltung der eingangs genannten Art, die Anschwingdauer erheblich zu verkürzen.

Diese Aufgabe wird bei einer gattungsgemäßen Quarzoszillatorschaltung durch die Merkmale des kennzeichnenden Teils des Patentanspruchs 1 gelöst.

Weiterbildungen der Erfindung sind Gegenstand von Unteransprüchen.

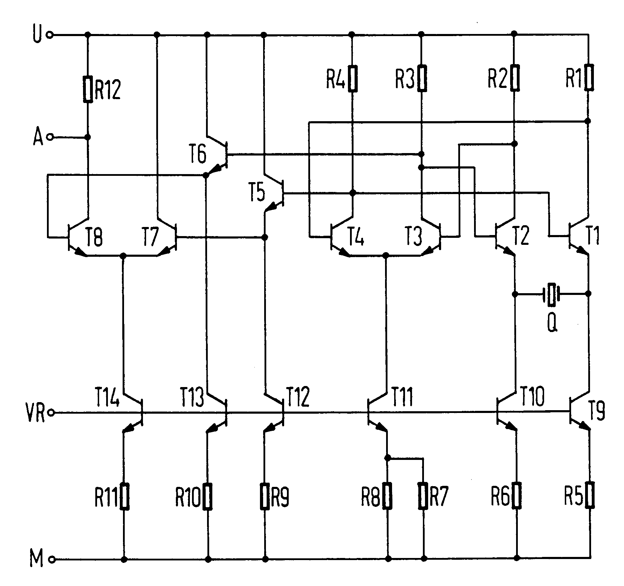

Die Erfindung wird nachfolgend anhand von dem in der einzigen Figur der Zeichnung dargestellten Ausführungsbeispiel näher erläutert.

Das Ausführungsbeipiel zeigt eine erfindungsgemäße Quarzoszillatorschaltung, bestehend aus einem ersten Transistor T1 und einem zweiten Transistor T2, deren Emitter über einen Schwingquarz Q miteinander verbunden sind. Außerdem ist der Emitter des ersten Transistors T1 an den Kollektor eines neunten Transistors T9 angeschlossen, der wiederum emitterseitig über einen fünften Widerstand R5 an einem zweiten Pol M einer nicht dargestellten Versorgungsspannungsquelle liegt. In gleicher Weise ist auch der zweite Transistor T2 mit einem zehnten Transistor T10 und einem sechsten Widerstand R6 verschaltet. Die Basis des neunten Transistors T9 und des zehnten Transistors T10 sind an einen ersten Pol VR einer nicht dargestellten Referenzspannungsquelle, deren zweiter Pol mit dem zweiten Pol M der Versorgungsspannungsquelle identisch ist, geführt. Die Basis eines elften Transistors T11, dessen Emitter über einen siebten Widerstand R7 und einem dazu parallel geschalteten achten Widerstand R8 an den zweiten Pol M der Versorgungsspannungsquelle liegt, ist ebenfalls mit dem ersten Pol VR der Referenzspannungsquelle verbunden. Der Kollektor des elften Transistors T11 bildet seinerseits zusammen mit den gekoppelten Emittern eines in Differenzverstärkerschaltung betriebenen Transistorpaares, bestehend aus einem dritten Transistor T3 und einem vierten Transistor T4, einen Knotenpunkt. Der dritte Transistor T3 ist durch seine Basis zum einen über einen zweiten Widerstand R2 mit dem ersten Pol U der Versorgungsspannungsquelle und zum anderen mit dem Kollektor des zweiten Transistors T2 verschaltet und durch seinen Kollektor zum einen über einen dritten Widerstand R3 mit dem ersten Pol U der Versorgungsspannungsquelle und zum anderen mit der Basis des zweiten Transistors T2 verbunden. Entsprechend ist der Kollektor des vierten Transistors T4, der zudem über einen vierten Widerstand R4 an dem ersten Pol U einer Versorgungsspannungsquelle liegt, mit der Basis des ersten Transistors T1 verschaltet, dessen über einen ersten Widerstand R1 an dem ersten Pol U der Versorgungsspannungsquelle angeschlossener Kollektor wiederum mit der Basis des vierten Transistors T4 verbunden ist.

Der Einsatz eines in Differenzverstärkerschaltung betriebenen Transistorpaares (T3, T4) in Oszillatoren ist bekannt aus dem Dokument US-A-4 468 636, aber zwecks Temperaturkompensation.

Der Kollektor des vierten Transistors T4 ist in Weiterbildung der Erfindung darüber hinaus auf die Basis eines als Emitterfolger betriebenen fünften Transistors T5 geführt, der kollektorseitig mit dem ersten Pol U der Versorgungsspannungsquelle und emitterseitig mit dem Kollektor eines zwölften Transistors T12, dessen Emitter seinerseits über einen neunten Widerstand R9 an dem zweiten Pol M der Versorgungsspannungsquelle liegt, verbunden ist. In gleicher Weise wird auch ein sechster Transistor T6, dessen Basis mit dem Kollektor des dritten Transistors T3 erschaltet ist, in Verbindung mit einem dreizehnten Transistor T13 und einem zehnten Widerstand R10 als Emitterfolger eingesetzt. Die Basen des zwölften Transistors T12 und des dreizehnten Transistors T13 sind ebenso wie die Basis eines vierzehnten Iransistors T14, der emitterseitig über einen elften Widerstand R11 an den zweiten Pol M der Versorgungsspannungsquelle liegt, an den ersten Pol VR der Referenzspannungsquelle angeschlossen. Der Kollektor des vierzehnten Transistors T14 ist mit den gekoppelten Emittern eines als Differenzverstärker ausgelegten, aus einem siebten Transistor T7 und einem achten Transistor T8 bestehenden Transistorpaar zusammengeführt. Dabei ist der Kollektor des siebten Transistors T7 direkt und der Kollektor des achten Transistors T8, der gleichzeitig den Ausgangsanschluß A des Oszillators bildet, über einen zwölften Widerstand R 12 mit dem ersten Pol U der Versorgungsspannungsquelle verbunden.

Bei den im gezeigten Ausführungsbeispiel verwendeten Transistoren handelt es sich ausschließlich um NPN-Typen, wodurch der erste Pol U der Versorgungsspannungsquelle und der erste Pol VR der Referenzspannungsqulle gegenüber den jeweils zweiten Pol M als positiv festgelegt sind. Eine Realisierung mit PNP-Transistoren ist bei entsprechender Umpolung der Spannungsquellen in gleicher Weise möglich.

Nachdem zuvor der prinzipielle Aufbau der in der Zeichnung dargestellten Quarzoszillatorschaltung erläutert worden ist, wird nunmehr auf deren Arbeitsweise näher eingegangen.

Ausgehend von der bekannten Grundform eines emittergekoppelten Quarzmultivibrators, bestehend aus dem ersten und zweiten Transistor T1 und T2, dem ersten und zweiten Widerstand R1 und R2, dem Schwingquarz Q sowie zwei Stromeinprägungen, welche durch dem neunten Transistor T9 und dem fünften Widerstand R5 bzw. durch den zehnten Transistor T10 und den sechsten Widerstand R6 in Verbindung mit der in der Zeichnung nicht dargestellten Referenzspannungsquelle gebildet werden, ist das gezeigte Ausführungsbeispiel demgegenüber um eine Differenzverstärkerstufe erweitert. Letztere umfaßt den dritten und vierten Transistor T3 und T4, den dritten und vierten Widerstand R3 und R4, sowie den ebenfalls in Verbindung mit der Referenzspannungsquelle zu einer Stromeinprägung verschaltete, elfte Transistor T11 zusammen mit dem siebten und achten Widerstand R7 und R8. Die Differenzverstärkerstufe ist derart in die bekannte Quarzmultivibratorschaltung eingefügt, daß die üblicherweise jeweils zwischen Basis und Kollektor des ersten und zweiten Transistors T1 und T2 bestehende Kreuzkopplung aufgetrennt und die Differenzverstärkerstufe phasengleich dazwischengeschaltet ist. Der Vorteil liegt darin, daß durch höhere Verstärkung im Oszillatorkreis der eingeschwungene Zustand des Quarzoszillators schneller erreicht wird, ohne jedoch die Emitterströme des ersten und zweiten Transistors T1 und T2 im Arbeitspunkt zu erhöhen.

Da in Weiterbildung der Erfindung erster, zweiter, dritter und vierter Widerstand R1, R2, R3 und R4 jeweils den gleichen Widerstandswert aufweisen und der erste, zweite, dritte und vierte Transistor T1, T2, T3 und T4 identisch aufgebaut sind, ergeben sich zusammen mit der Bedingung, daß auch die Ströme durch die eben genannten Transistoren gleich sind, gleiche Arbeitspunkte für den ersten, zweiten, dritten und vierten Transistor T1, T2, T3 und T4 unabhängig von der Versorgungsspannungsquelle. Dies bringt den Vorteil mit sich, daß Spannungsschwankungen der Versorgungsspannungsquelle in einem weiten Bereich keinen wesentlichen Einfluß auf die Arbeitsweise des Quarzoszillators ausüben und ein sicheres Anschwingen gewahrleistet wird.

In dem gezeigten Ausführungsbeispiel sind der neunte, zehnte und elfte Transistor T9, T10 und T11 zusammen mit dem jeweils zugehörigen fünften, sechsten und siebten bzw. achten Widerstand R5, R6 und R7, R8 in Verbindung mit der Referenzspannungsquelle zu Stromeinprägungen verschaltet. Die eben genannten Widerstände weisen dabei jeweils gleiche Widerstandswerte auf. Durch die Parallelschaltung des siebten und achten Widerstandes R7, R8 ergibt sich für die aus dem elften Transistor T11 aufgebaute Stromeinprägung der doppelte Strom, wobei zweckmäßigerweise die Emitterfläche des ersten Transistors T11 verdoppelt wird, um die gleiche Stromdichte wie in dem neunten und zehnten Transistor T9 und T10 zu erhalten. Insgesamt ergeben sich damit im Arbeitspunkt für den dritten und vierten Transistor T3 und T4 die gleichen Emitterkollektorströme wie für den ersten und zweiten Transistor T1 und T2. Darüber hinaus ist insbesondere bei Integration der gezeigten Quarzoszillatorschaltung ein Parallelschalten des siebten und achten Widerstandes R7 und R8 vorteilhaft, weil dadurch ein identischer Aufbau des fünften, sechsten, siebten und achten Widerstandes R5, R6, R7 und R8 ermöglicht wird.

Die an den Kollektoren des vierten Transistors T4 und des dritten Transistors T3 anliegenden Ausgangssignale werden in Weiterbildung der Erfindung einer aus dem fünften, sechsten, siebten und achten Transistor T5, T6, T7 und T8, sowie den zugehörigen Stromeinprägungen mit zwölftem, dreizehntem, vierzehntem Transistor T12, T13, T14 und neuntem, zehntem, elftem und zwölftem Widerstand R9, R10, R11 und R12 bestehenden Verstärkerschaltung zugeleitet. Deren Vorteil liegt in einer rückwirkungsfreien Auskopplung der Ausgangssignale.

## Patentansprüche

1. Oszillatorschaltung für hohe Frequenzen, bestehend aus einem ersten Transistor (T1), der kollektorseitig über einen ersten Widerstand (R1) an einem ersten Pol (U) einer Versorgungsspannungsquelle liegt, aus einem zweiten Transistor (T2), der kollektorseitig über einen zweiten Widerstand (R2) an dem ersten Pol (U) der Versorgungsspannungsquelle liegt, aus zwei identischen Stromeinprägungen (T9, R5, T10, R6), welche den Emitter des ersten und zweiten Transistors (T1, T2) jeweils mit einem zweiten Pol (M) der Versorgungsspannungsquelle verbinden, und aus einem Schwingquarz (Q) der zwischen die Emitter der beiden Transistoren (T1, T2) geschaltet ist, **dadurch gekennzeichnet**, daß eine dritte Stromeinprägung (T11, R7, R8) den zweiten Pol (M) der Versorgungsspannungsquelle mit den gekoppelten Emittern eines dritten Transistors (T3), der kollektorseitig über einen dritten Widerstand (R3) an dem ersten Pol (U) der Versorgungsspanungsquelle liegt, und eines vierten Transistor (T4), der kollektorseitig über einen vierten Widerstand (R4) an dem ersten Pol (U) der Versorgungsspannungsquelle liegt, verbindet, daß die Basis des dritten Transistors (T3) mit dem Kollektor des zweiten Transistors (T2), die Basis des vierten Transistors (T4) mit dem Kollektor des ersten Transistors (T1), die Basis des zweiten Transistors (T2) mit dem Kollektor des dritten Transistors (T3) und die Basis des ersten Transistors (T1) mit dem Kollektor des vierten Transistors (T4) verschaltet ist und daß die Ausgangssignale an den Kollektoren des dritten und vierten Transistors (T3, T4) anliegen.

2. Oszillatorschaltung nach Anspruch 1, **dadurch gekennzeichnet**, daß erster, zweiter, dritter und vierter Widerstand (R1, R2, R3, R4) den gleichen Widerstandswert aufweisen, daß erster, zweiter, dritter und vierter Transistor (T1, T2, T3, T4) identisch ausgeführt sind und daß die dritte Stromeinprägung (T11, R7, R8) derart aufgebaut ist, daß der durch sie eingeprägte Strom gleich der Summe der gleichgroßen Ströme der ersten Stromeinprägung (T9, R5) und der zweiten Stromeinprägung (T10, R6) ist.

3. Oszillatorschaltung nach Anspruch 1 oder 2, **dadurch gekennzeichnet**, daß der Kollektor des vierten Transistors (T4) mit der Basis eines fünften Transistors (T5), der kollektorseitig an dem ersten Pol (U) und emitterseitig über eine vierte Stromeinprägung (T12, R9) an den zweiten Pol (M) der Versorgungsspannungsquelle angeschlossen ist, verbunden ist, daß der Kollektor des dritten Transistors (T3) zu der Basis eines sechsten Transistors (T6), der kollektorseitig an den ersten Pol (U) und emitterseitig über eine fünfte Stromeinprägung (T13, R10) an den zweiten Pol (M) der Versorgungsspannungsquelle angeschlossen ist, verschaltet ist und daß eine sechste Stromeinprägung (T14, R11) den zweiten Pol (M) der Versorgungsspannungsquelle mit den gekoppelten Emittern eines siebten Transistors (T7), dessen Kollektor an den ersten Pol (U) der Versorgungsspannungsquelle und dessen Basis an den Emitter des fünften Transistors (T5) angeschlossen ist, und eines achten Transistors (T8), dessen Basis mit dem Emitter des sechsten Transistors (T6) und dessen über einen fünften Widerstand (R 12) am ersten Pol (U) der Versorgungsspannungsquelle liegender Kollektor mit dem Ausgangsanschluß (A) verschaltet ist, verbindet.

## Claims

1. Oscillator circuit for high frequencies, comprising a first transistor (T1) which is connected on the collector side to a first pole (U) of a supply voltage source via a first resistor (R1), a second transistor (T2) which is connected on the collector side to the first pole (U) of the supply voltage source via a second resistor (R2), two identical current injection means (T9, R5, T10, R6) which connect the emitter of the first and second transistor (T1, T2) to a second pole (M) of the supply voltage source in each case, and an oscillator crystal (Q) which is connected between the emitters of the two transistors (T1, T2), characterized in that a third current injection means (T11, R7, R8) connects the second pole (M) of the supply voltage source to the coupled emitters of a third transistor (T3), which is connected on the collector side to the first pole (U) of the supply voltage source via a third resistor (R3), and of a fourth transistor (T4), which is connected on the collector side to the first pole (U) of the supply voltage source via a fourth resistor (R4), in that the base of the third transistor (T3) is connected to the collector of the second transistor (T2), the base of the fourth transistor (T4) is connected to the collector of the first transistor (T1), the base of the second transistor (T2) is connected to the collector of the third transistor (T3) and the base of the first transistor (T1) is connected to the collector of the fourth transistor (T4), and in that the output signals are present at the collectors of the third and fourth transistor (T3, T4).

2. Oscillator circuit according to Claim 1, characterized in that first, second, third and fourth resistors (R1, R2, R3, R4) have the same resistance value, in that first, second, third and fourth transistors (T1, T2, T3, T4) are of identical design, and in that the third current injection means (T11, R7, R8) is designed in such a way that the current injected by it is equal to the sum of the equal-magnitude currents of the first current injection means (T9, R5) and of the second current injection means (T10, R6).

3. Oscillator circuit according to Claim 1 or 2, characterized in that the collector of the fourth transistor (T4) is connected to the base of a fifth transistor (T5), which is connected on the collector side to the first pole (U) and on the emitter side to the second pole (M) of the supply voltage source via a fourth current injection means (T12, R9), in that the collector of the third transistor (T3) is connected to the base of a sixth transistor (T6), which is connected on the collector side to the first pole (U) and on the emitter side to the second pole (M) of the supply voltage source via a fifth current injection means (T13, R10), and in that a sixth current injection means (T14, R11) connects the second pole (M) of the supply voltage source to the coupled emitters of a seventh transistor (T7), the collector of which is connected to the first pole (U) of the supply voltage source and the base of which is connected to the emitter of the fifth transistor (T5), and of an eighth transistor (T8), the base of which is connected to the emitter of the sixth transistor (T6) and the collector of which, which is connected to the first pole (U) of the supply voltage source via a fifth resistor (R12), is connected to the output terminal (A).

## Revendications

1. Circuit oscillateur pour des fréquences élevées, constitué par un premier transistor (T1), dont le côté collecteur est raccordé, par l'intermédiaire d'une première résistance (R1), à une première borne (U) d'une source de tension d'alimentation par un second transistor (T2), dont le côté collecteur est raccordé, par l'intermédiaire d'une seconde résistance (R2), à la première borne (U) de la source de tension d'alimentation, par deux unités identiques d'injection de courant (T9, R5, T10, R6), qui relient l'émetteur des premier et second transistors (T1, T2) respectivement à une seconde borne (M) de la source de tension d'alimentation, et par un quartz oscillateur (Q), qui est branché entre les émetteurs des deux transistors (T1, T2), caractérisé par le fait qu'une troisième unité d'injection de courant (T11, R7, R8) relie la seconde borne (M) de la source de tension d'alimentation aux émetteurs couplés d'un troisième transistor (T3), dont le côté collecteur est raccordé, par l'intermédiaire d'une troisième résistance (R3), à la première borne (U) de la source de tension d'alimentation, et d'un quatrième transistor (T4), dont le côté collecteur est raccordé, par l'intermédiaire d'une quatrième résistance (R4), à la première borne (U) de la source de tension d'alimentation, que la base du troisième transistor (T3) est connectée au collecteur du second transistor (T2), que la base du quatrième transistor (T4) est connectée au collecteur du premier transistor (T1), que la base du second transistor (T2) est connectée au collecteur du troisième transistor (T3) et que la base du premier transistor (T1) est connectée au collecteur du quatrième transistor (T4), et que les signaux de sortie sont présents sur les collecteurs des troisième et quatrième transistors (T3,T4).

2. Circuit oscillateur suivant la revendication 1, caractérisé par le fait que les première, seconde, troisième et quatrième résistances (R1, R2, R3, R4) possèdent la même valeur résistive, que les premier, second, troisième et quatrième transistors (T1, T2, T3, T4) sont identiques et que la troisième unité d'injection de courant (T11, R7, R8) est agencée de telle sorte que le courant, qu'elle injecte, est égal à la somme des courants de même intensité de la première unité d'injection de courant (T9, R5) et de la seconde unité d'injection de courant (T10, R6).

3. Circuit oscillateur suivant la revendication 1 ou 2, caractérisé par le fait que le collecteur du quatrième transistor (T4) est raccordé à la base d'un cinquième transistor (T5), dont le côté collecteur est raccordé à la première borne (U) et dont le côté émetteur est raccordé, par l'intermédiaire d'une quatrième unité d'injection de courant (T12, R9), à la seconde borne (M) de la source de tension d'alimentation, que le collecteur du troisième transistor (T3) est raccordé à la base d'un sixième transistor (T6), dont le côté collecteur est raccordé, à la première borne (U) et dont le côté émetteur est raccordé, par l'intermédiaire d'une cinquième unité de courant (T13, R10), à la seconde borne (M) de la source de tension d'alimentation, et qu'une sixième unité d'injection de courant (T14, R11) relie la seconde borne (M) de la source de tension d'alimentation aux émetteurs couplés d'un septième transistor (T7), dont le côté collecteur est connecté à la première borne (U) de la source de tension d'alimentation et dont la base est connectée à l'émetteur du cinquième transistor (T5), et d'un huitième transistor (T8), dont la base est connectée à l'émetteur du sixième transistor (T6) et dont le collecteur, qui est raccordé, par l'intermédiaire d'une cinquième résistance (R12), à la première borne (U) de la source de tension d'alimentation, est connecté à la borne de sortie (A).
